# EUROPEAN PATENT SPECIFICATION

(11) **EP 2 853 902 B1**
(45) Date of publication and mention of the grant of the patent: **08.11.2017**
(21) Application number: 14186465.2
(22) Date of filing: 25.09.2014
(51) Int. Cl.: G01R 1/067, G01R 35/00, G01R 31/319, G01R 27/32, G01R 31/28

(54) **Switched load time-domain reflectometer de-embed probe**
Ausgebettete Sonde eines Zeitbereichsreflektometers mit geschalteter Last
Sonde à effet soustrait de réflectomètre temporel de charge commutée

(30) Priority: 25.09.2013 US 201361882292 P; 25.04.2014 US 201414261834
(43) Date of publication of application: 01.04.2015
(73) Proprietor: Tektronix, Inc., Beaverton, Oregon 97077-0001 (US)
(72) Inventor: Pickerd, John, Beaverton, OR 97077-0001 (US); Tan, Kan, Beaverton, OR 97077-0001 (US)
(74) Representative: HGF Limited

(56) References cited:
- EP-A1- 2 680 452
- US-A1- 2006 269 186
- US-A1- 2008 048 677
- US-B1- 6 870 359
- BEYENE W T ET AL: "Advanced Modeling and Accurate Characterization of a 16 Gb/s Memory Interface", IEEE TRANSACTIONS ON ADVANCED PACKAGING, IEEE SERVICE CENTER, PISCATAWAY, NJ, USA, vol. 32, no. 2, 1 May 2009 (2009-05-01), pages 306-327, XP011346258, ISSN: 1521-3323, DOI: 10.1109/TADVP.2009.2018460

## Description

### TECHNICAL FIELD

The disclosed technology relates generally to signal acquisition systems, and more particularly, to a de-embed probe with switched loads and an internal signal generator for reducing measurement errors due to the probe tip loading of a device under test.

### BACKGROUND

Traditionally a vector network analyzer or a time-domain reflectometer (TDR) system with a sampling oscilloscope has been required to obtain scattering parameter (S-parameter) measurements for characterizations of a device under test (DUT). Once the S-parameters of the fixture have been measured and the S-parameters of the device under test have been measured, then a full de-embed operation can be performed to obtain only characteristics of the device under test.

De-embed probes as described in U.S. Patent No. 7,460,983 titled SIGNAL ANALYSIS SYSTEM AND CALIBRATION METHOD, U.S. Patent No. 7,414,411 titled SIGNAL ANALYSIS SYSTEM AND CALIBRATION METHOD FOR MULTIPLE SIGNAL PROBES, U.S. Patent No. 7,408,363 titled SIGNAL ANALYSIS SYSTEM AND CALIBRATION METHOD FOR PROCESSING ACQUIRES SIGNAL SAMPLES WITH AN ARBITRARY LOAD, and U.S. Patent No. 7,405,575 titled SIGNAL ANALYSIS SYSTEM AND CALIBRATION METHOD FOR MEASURING THE IMPEDANCE OF A DEVICE UNDER TEST use switched loads inside the probes across the probe tips to take measurements. The S-parameters of the de-embed probe are measured at manufacturing time and stored in an S-parameter memory inside the probes. A user then connects a probe to the device under test and presses a calibration button. The scope takes two or three averaged acquisitions each with a different de-embed load switched across the probe tip.

After the acquisitions, the oscilloscope can compute the impedance of the device under test as a function of frequency and also provide a fully de-embedded view of the waveform at the device under test as if the probe and oscilloscope had never been connected. This can also be done by incorporating the above discussed method into a vector network analyzer using two de-embed probe fixtures with a signal source and a setup to operate as a vector network analyzer using two de-embed probes, as discussed in U.S. Provisional Application No. 61/882,283, filed September 25, 2013, titled "TWO PORT VECTOR NETWORK ANALYZER USING DE-EMBED PROBES," and filed as a regular utility application U.S. Serial No. 14/267,697 on May 1, 2014.

U.S. Provisional Application No. 61/882,298, filed September 25, 2013, titled "ALTERNATE METHOD OF PROVIDING DE-EMBED PROBE FUNCTIONALITY" discloses a TDR de-embed probe. This probe contains no switched loads but contains an internal TDR generator that is always attached across the TDR de-embed probe tips. The S-parameters of this generator are measured at manufacturing and stored in the probe. When the TDR de-embed probe is connected to either an active or passive device under test, a triggering scheme is used to desynchronize the device under test waveform with the TDR pulser to average the device under test signal to zero so the result can be measured. From the measured result, the de-embedded waveform can be computed.

What is needed is a de-embed probe that can be used to measure both active and passive devices under test with or without a device under test signal source.

Document US2006269186 discloses micro-machined MEMS switches of a test instrument where the MEMS switches can be fabricated on the same substrate as the attenuators, or the switches or attenuators can be mounted on the same substrate as the others are fabricated.

Document US2008048677 discloses a method and apparatus adapted to calibrate a signal path of a signal analysis system such that digital samples of a signal under test acquired by the system are processed for representing the impedance of a device under test.

Document US 6870359 discloses a self-calibrating test probe system that does not require probing head removal and replacement because the test probe and/or the entire system (including a testing instrument) may be calibrated or may self-calibrate while the probing head remains connected to an electrical component under test.

### SUMMARY

There is provided a differential de-embed probe as set out in claims 1 and 13.

Certain embodiments of the disclosed technology include a de-embed probe, including two inputs configured to connect to a device under test, a memory, a signal generator configured to output a signal, a plurality of load components, a plurality of switches, and a controller. Each load component is configured to provide a different load. A first switch of the plurality of switches is associated with the signal generator and the other switches of the plurality of switches are each associated with one load component. The controller is configured to control the plurality of switches to connect combinations of the loads from the plurality of load components and the signal from the signal generator across the two inputs.

Certain other embodiments of the disclosed technology include a de-embed probe including two inputs configured to connect to a device under test, a memory, a signal generator configured to output a signal, a load integrated circuit with a plurality of different loads, a plurality of switches, a first switch of the plurality of switches is associated with the signal generator and the other switches of the plurality of switches are each associated with a load of the load integrated circuit, and a controller configured to control the plurality of switches to connect combinations of loads from the load integrated circuit and the signal from the signal generator across the two inputs.

Certain other embodiments include a test and measurement system, including a device under test, a test and measurement instrument, and a de-embed probe of the disclosed technology as described below.

### BRIEF DESCRIPTION OF THE DRAWINGS

FIG. 1 illustrates a block diagram of a de-embed probe of the disclosed technology.
FIG. 2 illustrates a test and measurement system using the de-embed probe of FIG. 1.
FIG. 3 illustrates a block diagram of a de-embed probe according to another embodiment of the disclosed technology.

### DETAILED DESCRIPTION

In the drawings, which are not necessarily to scale, like or corresponding elements of the disclosed systems and methods are denoted by the same reference numerals.

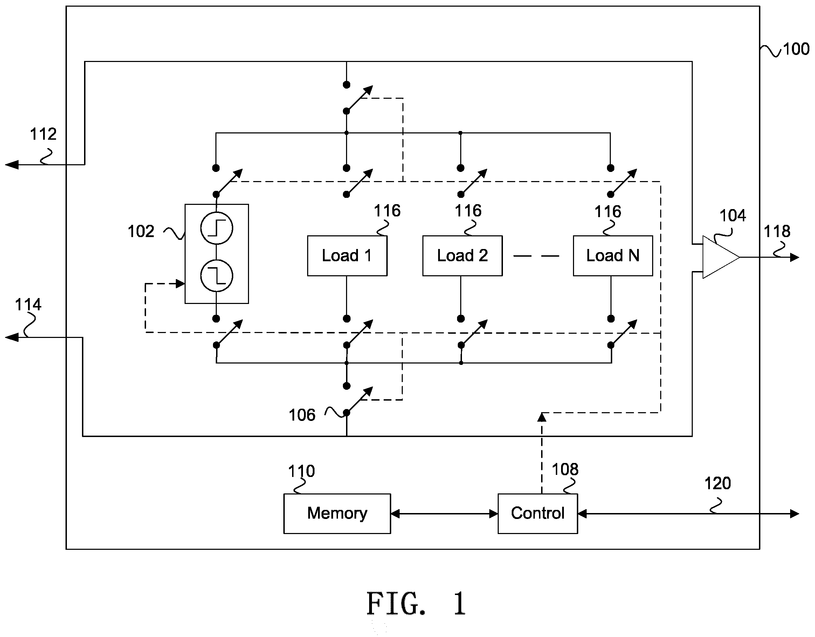

The disclosed technology includes a de-embed probe that includes both a signal generator and switched loads, as shown in FIG. 1. FIG. 1 depicts a de-embed probe 100 according to some embodiments of the disclosed technology. The de-embed probe 100 can be a standard probe with standard probe tips. The de-embed probe 100 can also be implemented as a plug-in module. Preferably, the de-embed probe 100 would be implemented as a probe compensation box with a subminiature version A (SMA) connector input. This configuration of the de-embed probe 100 would allow room for a signal generator 102 and other circuitry, as discussed in more detail below.

The de-embed probe 100 includes an amplifier 104 and also the typical circuitry generally found in de-embed probes and as discussed in the above discussed patent publications. The typical circuitry is not shown in FIG. 1.

The de-embed probe 100 also includes a set of switches 106. Some of the switches 106 may be analog switches within an integrated circuit. Further, some of the switches 106 may be microelectromechanical systems (MEMs). Other types of switches 106 may be incorporated such as relay contacts. The switches 106 are controlled by controller 108, as will be discussed in more detail below.

The de-embed probe 100 also includes a memory component 110. The memory 110 stores the measured S-parameters of the probe in each of the possible switch 106 positions used during operation of the probe. These S-parameters are used to provide a de-embedded view of the waveform depending on the position of the switches for the probe acquisitions. For example, the memory would store the S-parameters for the probe if only the signal generator 102 is switched to be connected to the probe inputs 112 and 114. And the memory 110 stores the S-parameters for the probe when the switches 106 are in all the other positions. The memory component 110 may also store typical functions that probes already incorporate. Further, memory component 110 may be made up of multiple memory components.

The de-embed probe 100 also includes a plurality of loads 116 that can be switched across the probe inputs 112 and 114. The loads 116 may be provided by either a load integrated circuit or discrete load components. A minimum of three loads 116 have to be switched across the probe inputs. However, the first load is considered to be when no loads are connected across the probe inputs. It is desirable and preferable to have numerous other loads so that the best loading for the device under test can be chosen by a user in a menu of the test and measurement instrument as discussed below.

The de-embed probe 100 also includes a signal generator 102, as mentioned above. If the de-embed probe 100 is a differential probe, then the signal generator 102 is also differential. However, if the de-embed probe is a single-ended de-embed probe (not shown), then the signal generator 102 is single-ended (not shown). That is, the de-embed probe may contain only a single input and a single output, rather than two inputs and one or more outputs. Preferably the signal generator 102 is a TDR pulse generator because a TDR pulse generator is easier to incorporate into the small size needed to fit into a probe. However, the signal generator 102 may be any type of signal generator, such a sine wave generator.

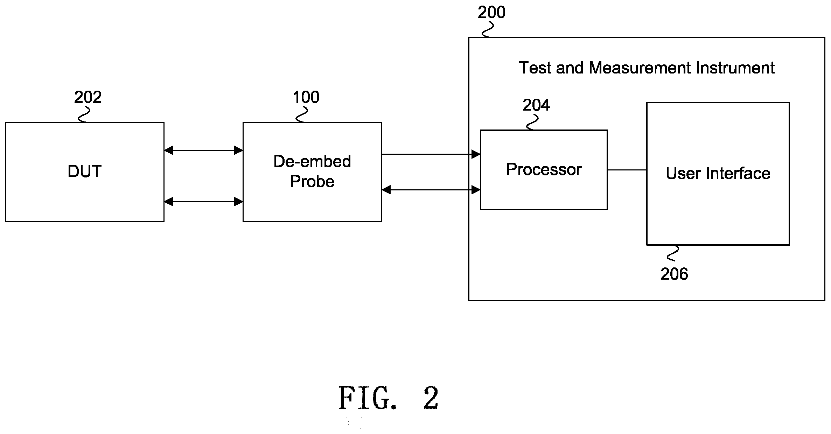

De-embed probe 100 also includes an output 118 from amplifier 104 that is sent to a test and measurement instrument as described in more detail below with respect to FIG. 2. The output 118 includes the waveforms from inputs 112 and 114 after they have traveled through the circuitry of probe 100 and the amplifier 104.

De-embed probe 100 described above with respect to FIG. 1 can be used in a test and measurement system as shown in FIG. 2. The de-embed probe 100 is connected to a test and measurement instrument 200 and a device under test 202.

De-embed probe 100 can be used with any type of test and measurement instrument 200 that can accept an input from a probe. The test and measurement instrument 200 has the responsibility of controlling via a processor 204 the controller 108 to control the switches 106 during operation via path 120. The processor 204 is also used to compute the math algorithms needed to perform the de-embed operations via a set of instructions stored in a memory and executed via the processor 204. The S-parameters of the test and measurement instrument 100 are stored in a memory (not shown) in the test and measurement instrument 100 to be used as a part of the total de-embed process to provide more accurate results.

The test and measurement instrument 200 also includes a user interface 206. A user is capable of controlling the de-embed probe 100 via the user interface 206. That is, the user can control what loads and how many loads are connected across the probe inputs 112 and 114.

The probe 100 may be attached to an extension cable to place the probe 100 closer to the device under test 202. A user may insert into the user interface 206 the S-parameters of any cable or fixture between the probe 100 and the device under test 200. These are loaded or inputted to the user interface 206 to be included in the de-embed operation performed by the processor 204.

The equations, math, and algorithms developed and defined in U.S. Patent No. 7,460,983 titled SIGNAL ANALYSIS SYSTEM AND CALIBRATION METHOD, U.S. Patent No. 7,414,411 titled SIGNAL ANALYSIS SYSTEM AND CALIBRATION METHOD FOR MULTIPLE SIGNAL PROBES, U.S. Patent No. 7,408,363 A1 titled SIGNAL ANALYSIS SYSTEM AND CALIBRATION METHOD FOR PROCESSING ACQUIRES SIGNAL SAMPLES WITH AN ARBITRARY LOAD, U.S. Patent No. 7,405,575 titled SIGNAL ANALYSIS SYSTEM AND CALIBRATION METHOD FOR MEASURING THE IMPEDANCE OF A DEVICE UNDER TEST, and U.S. Provisional Application No. 61/882,283, titled TWO PORT VECTOR NETWORK ANALYZER USING DE-EMBED PROBES, discussed above, may be used to derive algorithms to de-embed the acquired waveforms.

Previously, the signal source was the device under test being measured in the test and measurement system and only passive loads were switched across the probe inputs. In the disclosed technology, if the device under test is passive then the signal generator 102 is switched across the inputs of the probe 112 and 114 to measure the impedance of the device under test 202. The switched loads 116 are also used. The equations to perform the de-embed operation to obtain the characteristics of device under test 202 are the same as in the patent descriptions discussed above, except the signal generator 102 is located within the de-embed probe 100 rather than in the device under test 202.

If the device under test 202 is active and includes a signal, the signal generator 102 is still switched across the inputs of the probes 112 and 114 along with the switched loads 116. The signal from the active device under test 202 must be random with respect to the signal from the signal generator 102. Then, a desynchronizing random delay trigger method may be used to insure that the device under test signal 202 averages to zero while the internal signal from the signal generator 102 does not. This provides an acceptable signal to noise ratio for the measurement. The random delay trigger would reside within the test and measurement instrument 200. Compared with U.S. Provisional Application No. 61/882,298, titled "ALTERNATE METHOD OF PROVIDING DE-EMBED PROBE FUNCTIONALITY," the plurality of loads can be switched in to be used with the signal generator 102, and the de-embed results obtained from various loads can be then averaged to improve the accuracy.

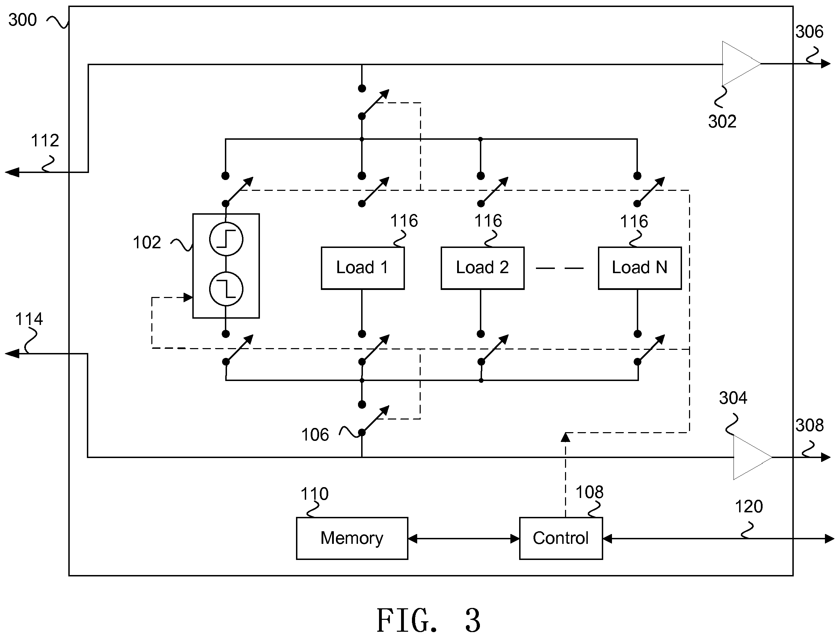

The probe of the disclosed technology is not limited to a three-port probe 100 as shown in FIG. 1. The probe may also be a four-port probe 300 as shown in FIG. 3. Rather than the acquisition from inputs 112 and 114 traveling to a single amplifier 104 and a single output 118, each input 112 and 114 includes an amplifier 302 and 304, respectively, and an output 306 and 308, respectively. Probe 300, however, would still operate in the same manner as probe 100 discussed above with respect to the signal generator 102, loads 116, and switches 106.

With a four-port probe 300 as shown in FIG. 3, both of the input waveforms from inputs 112 and 114 pass through the probe 300 to the test and measurement instrument. Both these waveforms may then be used in the measurement of S-parameter modeling processor to result in the desired de-embedding of the test equipment to provide a true waveform from the device under test. With the differential signal from the device under test fully represented by two waveforms, a user may be interested in any of four possible output waveforms: (1) a differential mode, which is the difference between the two waveforms on the two sides; (2) a common mode which is the sum of the two waveforms divided by 2; and (3) showing only one of the other waveforms. If the probe is only a three-port probe 100 as shown in FIG. 1, then the de-embedding operation only looks at the differential mode waveform.

The test and measurement instrument 200 may be an oscilloscope or spectrum analyzer. As mentioned above, the test and measurement instrument 200 includes a processor 204 and a memory (not shown) to store executable instructions. Such executable instructions may be computer readable code embodied on a computer readable medium, which when executed, causes the computer or processor to perform any of the above-described operations. As used here, a computer is any device that can execute code. Microprocessors, programmable logic devices, multiprocessor systems, digital signal processors, personal computers, or the like are all examples of such a computer. In some embodiments, the computer readable medium can be a tangible computer readable medium that is configured to store the computer readable code in a non-transitory manner. The scope of the invention is defined by the appended claims.

## Claims

1. A differential de-embed probe (100), comprising:
two inputs configured to connect to a device under test (202);
a memory (110);
a signal generator (102) configured to output a differential signal, including a first and a second signal;
a plurality of load components (116), each load component configured to provide a different load;
a plurality of switches, a first and second switch of the plurality of switches associated with the signal generator (102) and the other switches of the plurality of switches each associated with one load component, the first and second switch each configured to connect at least one of the first signal and the second signal to one of the two inputs; and
a controller (108) configured to control the plurality of switches to connect combinations of the loads from the plurality of load components and the signal from the signal generator (102) across the two inputs.

2. The de-embed probe (100) of claim 1, wherein the memory (108) is configured to store measured S-parameters of the de-embed probe (100) in each switch position of the plurality of switches.

3. The de-embed probe (100) of claim 1 or 2, wherein the signal generator (102) is a time-domain reflectometer pulse signal generator.

4. The de-embed probe (100) of claim 1 or 2, wherein the signal generator (102) is a sine wave generator.

5. A test and measurement system, comprising:
a test and measurement instrument (200); and
the de-embed probe (100) of any of claims 1-4.

6. The test and measurement system of claim 5, wherein the de-embed probe (100) further comprises an output connected to the test and measurement instrument (200), the output configured to provide a measurement from the two inputs.

7. The test and measurement system of claim 5, wherein the de-embed probe (300) further comprises a first output connected to one of the two inputs and a second output connected to the other of the two inputs, each of the outputs configured to output an input waveform from a respective one of the two inputs.

8. The test and measurement system of any of claims 5-7, wherein the test and measurement instrument (200) includes:
a user interface configured to receive a user input to control the probe; and
a processor configured to send instructions to the controller (108) based on the user input.

9. The test and measurement system of any of claims 5-8, wherein the test and measurement instrument (200) is an oscilloscope.

10. The test and measurement system of any of claims 5-8, wherein the test and measurement instrument (200) is a spectrum analyzer.

11. The test and measurement system of any of claims 5-10, further comprising a device under test (202), wherein the device under test (202) is a passive device under test.

12. The test and measurement system of any of claims 5-10, further comprising a device under test (202), wherein the device under test (202) is an active device under test.

13. A differential de-embed probe (100), comprising:
two inputs configured to connect to a device under test (202);
a memory (110);
a signal generator (102) configured to output a differential signal including a first signal and a second signal;
a load integrated circuit with a plurality of different loads;
a plurality of switches, a first and second switch of the plurality of switches associated with the signal generator (102) and the other switches of the plurality of switches each associated with one load of the load integrated circuit, the first and second switch each configured to connect at least one of the first signal and the second signal to one of the two inputs; and
a controller (108) configured to control the plurality of switches to connect combinations of loads from the load integrated circuit and the signal from the signal generator across the two inputs.

14. A test and measurement system, comprising:
a test and measurement instrument (200); and
the de-embed probe of claim 13.

## Patentansprüche

1. Differenzielle "De-Embedding" Sonde (100), umfassend:
Zwei Eingänge, die konfiguriert sind, mit einem Messobjekt (202) verbunden zu werden;
einen Speicher (110);
einen Signalgenerator (102), der konfiguriert ist, ein Differenzsignal auszugeben, das ein erstes und ein zweites Signal einschließt;
eine Vielzahl von Lastkomponenten (116), wobei jede Lastkomponente konfiguriert ist, eine verschiedene Last bereitzustellen;
eine Vielzahl von Schaltern, wobei ein erster und zweiter Schalter der Vielzahl von Schaltern mit dem Signalgenerator (102) verbunden sind und die anderen Schalter der Vielzahl von Schaltern jeweils mit einer Lastkomponente verbunden sind, wobei der erst und zweite Schalter jeweils konfiguriert ist, mindestens eins des ersten Signals und des zweiten Signals mit einem der zwei Eingänge zu verbinden; und
ein Steuergerät (108), das konfiguriert ist, die Vielzahl von Schaltern zu steuern, um Kombinationen von Lasten ab der Vielzahl von Lastkomponenten und das Signal vom Signalgenerator (102) über die zwei Eingänge zu verbinden.

2. "De-Embedding" Sonde (100) nach Anspruch 1, wobei der Speicher (108) konfiguriert ist, gemessene S-Parameter der "De-Embedding" Sonde (100) in jeder Schalterposition der Vielzahl von Schaltern zu speichern.

3. "De-Embedding" Sonde (100) nach Anspruch 1 oder 2, wobei der Signalgenerator (102) ein Zeitbereichsreflektometer-Impulssignalgenerator ist.

4. "De-Embedding" Sonde (100) nach Anspruch 1 oder 2, wobei der Signalgenerator (102) ein Sinuswellengenerator ist.

5. Prüf- und Messsystem, umfassend: ein Prüf- und Messinstrument (200); und die "De-Embedding" Sonde (100) nach einem der Ansprüche 1-4.

6. Prüf- und Messsystem nach Anspruch 5, wobei die "De-Embedding" Sonde (100) ferner einen Ausgang umfasst, der mit dem Prüf- und Messinstrument (200) verbunden ist, wobei der Ausgang konfiguriert ist, eine Messung ab den zwei Eingängen bereitzustellen.

7. Prüf- und Messsystem nach Anspruch 5, wobei die "De-Embedding" Sonde (300) ferner einen ersten Ausgang, der mit einem der zwei Eingänge verbunden ist und einen zweiten Ausgang umfasst, der mit dem anderen der zwei Eingänge verbunden ist, wobei jeder der Ausgänge konfiguriert ist, eine Eingangswellenform ab einem jeweiligen Eingang der zwei Eingänge auszugeben.

8. Prüf- und Messsystem nach einem der Ansprüche 5-7, wobei das Prüf- und Messinstrument (200) einschließt:
eine Benutzerschnittstelle, die konfiguriert ist, eine Benutzereingabe zu empfangen, um die Sonde zu steuern; und
einen Prozessor, der konfiguriert ist, auf der Benutzereingabe basierende Befehle an das Steuergerät (108) zu senden.

9. Prüf- und Messsystem nach einem der Ansprüche 5-8, wobei das Prüf- und Messinstrument (200) ein Oszilloskop ist.

10. Prüf- und Messsystem nach einem der Ansprüche 5-8, wobei das Prüf- und Messinstrument (200) ein Spektrumanalysator ist.

11. Prüf- und Messsystem nach einem der Ansprüche 5-10, das ferner ein Messobjekt (202) umfasst, wobei das Messobjekt (202) ein passives Messobjekt ist.

12. Prüf- und Messsystem nach einem der Ansprüche 5-10, das ferner ein Messobjekt (202) umfasst, wobei das Messobjekt (202) ein aktives Messobjekt ist.

13. Differenzielle "De-Embedding" Sonde (100), umfassend:
Zwei Eingänge, die konfiguriert sind, mit einem Messobjekt (202) verbunden zu werden;
einen Speicher (110);
einen Signalgenerator (102), der konfiguriert ist, ein Differenzsignal auszugeben, das ein erstes Signal und ein zweites Signal einschließt;
einen integrierten Schaltkreis für Last mit einer Vielzahl verschiedener Lasten;
eine Vielzahl von Schaltern, einen ersten und zweiten Schalter der Vielzahl von Schaltern, die mit dem Signalgenerator (102) und den anderen Schaltern der Vielzahl von Schaltern verbunden sind, wobei jeder mit einer Last des integrierten Schaltkreises verbunden ist, wobei der erste und zweite Schalter jeweils konfiguriert ist, mindestens eins des ersten Signals und des zweiten Signals mit einem der zwei Eingänge zu verbinden; und
ein Steuergerät (108), das konfiguriert ist, die Vielzahl von Schaltern zu steuern, um Kombinationen von Lasten vom integrierten Schaltkreis für Last und das Signal vom Signalgenerator über die zwei Eingänge zu verbinden.

14. Prüf- und Messsystem, umfassend: ein Prüf- und Messinstrument (200); und die "De-Embedding" Sonde nach Anspruch 13.

## Revendications

1. Sonde de désintégration différentielle (100), comprenant :
deux entrées configurées pour se raccorder à un dispositif en cours d'essai (202) ;
une mémoire (110) ;
un générateur de signal (102) configuré pour produire un signal différentiel, comprenant un premier et un deuxième signal ;
une pluralité de composants de charge (116), chaque composant de charge étant configuré pour fournir une charge diverse ;
une pluralité de commutateurs, un premier et un deuxième commutateur de la pluralité de commutateurs associés avec le générateur de signal (102), et les autres commutateurs de la pluralité de commutateurs, chacun étant associé avec un composant de charge, le premier et le deuxième commutateur étant chacun configuré pour connecter au moins un des premier et deuxième signaux à une des deux entrées ; et
un régulateur (108) configuré pour contrôler la pluralité de commutateurs pour connecter des combinaisons des charges de la pluralité de composants de charge et le signal provenant du générateur de signaux (102) sur les deux entrées.

2. Sonde de désintégration (100) selon la revendication 1, la mémoire (108) étant configurée pour stocker des paramètres S mesurés de la sonde de désintégration (100) dans chaque position de commutateur de la pluralité de commutateurs.

3. Sonde de désintégration (100) selon la revendication 1 ou 2, le générateur de signaux (102) étant un générateur de signaux d'impulsions de réflectomètre temporel.

4. Sonde de désintégration (100) selon la revendication 1 ou 2, le générateur de signaux (102) étant un générateur d'ondes sinusoïdales.

5. Système d'essai et de mesure, comprenant :
un instrument d'essai et de mesure (200) ; et
la sonde de désintégration (100) selon une quelconque des revendications 1 à 4.

6. Système d'essai et de mesure selon la revendication 5, la sonde de désintégration (100) comprenant en outre une sortie connectée à l'instrument d'essai et de mesure (200), la sortie étant configurée pour fournir une mesure d'après les deux entrées.

7. Système d'essai et de mesure selon la revendication 5, la sonde de désintégration (300) comprenant en outre une première entrée connectée à une des deux entrées et une deuxième entrée connectée à l'autre des deux entrées, chacune des sorties étant configurée pour sortir une forme d'onde d'entrée depuis une entrée respective des deux entrées.

8. Système d'essai et de mesure selon une quelconque des revendications 5 à 7, l'instrument d'essai et de mesure (200) comprenant :
une interface utilisateur configurée pour recevoir une entrée utilisateur pour contrôler la sonde ; et
un processeur configuré pour envoyer des instructions au régulateur (108) en fonction de l'entrée utilisateur.

9. Système d'essai et de mesure selon une quelconque des revendications 5 à 8, l'instrument d'essai et de mesure (200) étant un oscilloscope.

10. Système d'essai et de mesure selon une quelconque des revendications 5 à 8, l'instrument d'essai et de mesure (200) étant un analyseur de spectre.

11. Système d'essai et de mesure selon une quelconque des revendications 5 à 10, comprenant en outre un dispositif en cours d'essai (202), le dispositif en cours d'essai (202) étant un dispositif passif en cours d'essai.

12. Système d'essai et de mesure selon une quelconque des revendications 5 à 10, comprenant en outre un dispositif en cours d'essai (202), le dispositif en cours d'essai (202) étant un dispositif actif en cours d'essai.

13. Sonde de désintégration différentielle (100), comprenant :
deux entrées configurées pour connecter un dispositif en cours d'essai (202) ;
une mémoire (110) ;
un générateur de signal (102) configuré pour produire un signal différentiel, comprenant un premier et un deuxième signal ;
un circuit intégré de charge, avec une pluralité de différentes charges ;
une pluralité de commutateurs, un premier et un deuxième commutateur de la pluralité de commutateurs associés avec le générateur de signal (102), et les autres commutateurs de la pluralité de commutateurs, chacun étant associés avec une charge du circuit intégré de charge, le premier et le deuxième commutateur étant chacun configuré pour connecter au moins un des premier et deuxième signaux à une des deux entrées ; et
un régulateur (108) configuré pour contrôler la pluralité de commutateurs afin de connecter des combinaisons des charges du circuit intégré de charge et du signal provenant du générateur de signaux sur les deux entrées.

14. Système d'essai et de mesure comprenant :
un instrument d'essai et de mesure (200) ; et
la sonde de désintégration selon la revendication 13.
